# NEW EUROPEAN PATENT SPECIFICATION

(11) **EP 0 138 823 B2**
(45) Date of publication and mention of the opposition decision: **23.06.1993**
(45) Mention of the grant of the patent: 08.03.1989
(21) Application number: 84900355.3
(22) Date of filing: 12.12.1983
(51) Int. Cl.: G05F 3/20

(54) **A CURRENT SOURCE CIRCUIT HAVING REDUCED ERROR**
SPANNUNGSSCHALTUNG MIT VERMINDERTEN FEHLERN
CIRCUIT DE SOURCE DE COURANT A ERREUR REDUITE

(30) Priority: 28.02.1983 US 470039
(43) Date of publication of application: 02.05.1985
(73) Proprietor: MOTOROLA, INC., Schaumburg, IL 60196 (US)
(72) Inventor: SMITH, Michael, Davis, Austin, TX 78746 (US)
(74) Representative: Ibbotson, Harold
(86) International application number: PCT/US83/01961
(87) International publication number: WO 84/03372

(56) References cited:
- DE-A- 2 157 756
- US-A- 3 582 689
- US-A- 3 930 172
- US-A- 3 953 807
- US-A- 4 302 718
- US-A- 4 342 926
- US-A- 4 359 680
- US-A- 4 399 399
- US-A- 4 442 398
- ELECTRONICS INTERNATIONAL, vol. 54, no. 16, August 1981, pages 109-112, New York, US; R. KASH: "Building quality analog circuits with C-MOS logic arrays"
- Proc.IEEE,August 1968 pp 1368-1369 Gray and Meyer,"Analysis of Analog Integrated Circuits", Wiley,New York,1977 Chapter 4 pp 197-210

## Description

### Technical field

This invention relates generally to reference circuits and, more particularly, to current reference circuits which minimize output errors resulting from variations in power supply voltage and device size matching errors.

### Background art

Reference circuits which utilize either a base-to-emitter voltage, V_{BE}, or a delta V_{BE} to establish a reference voltage and current by both reference voltage means and reference current means are well known. Such a circuit is described in detail in U.S. Patent No. 4,342,926. Transistor devices which are size ratioed and coupled to the reference current in a conventional current mirror structure reflect the reference current to an output device which provides a bias voltage. Although known reference circuits may be made substantially process independent, power supply voltage independence typically exists only for power supply voltages of five volts or less. This is because most of the power supply voltage generally appears across a single transistor. Due to the conventional phenomenon known as channel length modulation, the transis- torwhich reflects the majority of power supply voltage displays a finite output impedance. As a result, a current mismatch exists between the reference voltage means and reference current means. Whenever a resistor type reference current means is utilized, the current mismatch translates into an offset voltage existing across the resistor. Further, as the supply voltage is increased, the offset voltage increases which creates a dependence on the supply voltage. Although this voltage error is generally insignificant for power supply voltages of five volts or less, the output error becomes increasingly worse at high voltage levels for N-channel conductivity devices due to the con- vential impact ionization phenomenon. P-channel conductivity devices also create an offset error but the offset error is not as pronounced as it is for N-channel conductivity devices at higher voltages.

A current source is known from DE-A-2157756 which includes two three-transistor Wilson current mirrors to provide a regulated output current and satisfactorily high output impedence.

### Brief Summary of the Invention

It is an object of the present invention to provide an improved current source circuit having reduced output error and a high output impedance. This is achieved in the present invention, by providing a current source circuit having reduced error, comprising:
a reference voltage means comprising a first bipolar transistor having a first current electrode and a control electrode connected together and coupled to a first supply voltage (VDD) for receiving a first supply voltage and having a second current electrode, said reference voltage means providing a reference voltage proportional to a bias current outputted by said current source circuit;
reference current means comprising a second bipolar transistor having a first current electrode coupled to the first supply voltage (VDD), a control electrode connected to the control electrode of the first bipolar transistor, and a second current electrode, and
a resistor having a first terminal connected to the second current electrode of the second bipolar transistor and a second terminal, said reference current means providing a reference current proportional to the reference voltage;
unity gain amplifier means having a predetermined ouput impedence, said amplifier means comprising a third, MOS, transistor of a first conductivity type having a first current electrode connected to the second current electrode of said first bipolar transistor, and a second current electrode and a control electrode which are connected together,
a fourth, MOS, transistor of said first conductivity type having a first current electrode connected to the second terminal of the resistor, a control electrode connected to both the control electrode and second current electrode of the third transistor, and a second current electrode,
a fifth, MOS, transistor of a second conductivity type having a first current electrode connected to the second current electrode of the fourth transistor, a second current electrode coupled to a second supply voltage terminal for receiving a second supply voltage (VSS), and a control electrode, and
a sixth, MOS, transistor of the second conductivity type having a first current electrode connected to a control electrode thereof and to the control electrode of the fifth transistor, and having a second current electrode coupled to the second supply voltage terminal (VSS), said unity gain amplifier means providing a bias voltage proportional to said reference current;
buffer means comprising a seventh, MOS, transistor of said second conductivity type having a first current electrode connected to the second current electrode of the third transistor, a second current electrode connected to the first current electrode of the sixth transistor, and a control electrode, and
an eighth, MOS, transistor of the second conductivity type having first and second current electrodes, and a control electrode connected to the control electrode of the seventh transistor, to the second current electrode of said fourth transistor and to the first current electrode of the fifth transistor, said buffer means substantially increasing the output impedence of said unity gain amplifier, thereby decreasing power supply variation dependency; and
bias current means comprising a ninth, MOS, transistor of the first conductivity type having a first current electrode coupled to the first supply voltage terminal (VDD), and a control electrode connected to both a second current electrode thereof and the first current electrode of the eighth transistor, and
a tenth, MOS, transistor of the second conductivity type having a first current electrode connected to the second current electrode of the eighth transistor, a control electrode connected to the control electrodes of the fifth and sixth transistors and to the first current electrode of the sixth transistor and having a second current electrode coupled to the second power supply voltage (VSS), said bias current means providing said output bias current, proportional to said bias voltage.

### Brief Description Of The Drawings

FIG. 1 illustrates in schematic form a current source circuit constructed in accordance with the preferred embodiment of the present invention; and
FIG. 2 illustrates in graphical form a reduction in output bias current error provided by the present invention.

### Description Of The Preferred Embodiment

Shown in the single drawing is a current source circuit 10 constructed in accordance with the preferred embodiment of the present invention. Current source 10 comprises generally reference voltage portion 11, reference current portion 12, unity gain amplifier portion 13, bias current portion 14 and buffer portion 15. It should readily be understood that the present invention may be practiced using any of numerous types of reference voltage means and reference current means. Two commonly known current sources utilize a base-to-emitter voltage V_{BE} and a delta V_{BE} to provide a reference current. The present invention may be readily adapted for use with other types of reference voltage and current means such as a power supply and resistor. For purposes of illustration only, a current source circuit utilizing delta V_{BE} will be described. Further, while specific N-channel and P-channel MOS devices are generally shown it should be clear that current source 10couid be implemented by completely reversing the processing techniques (e.g. N-channel to P-channel) or by using other types of transistors.

Reference voltage portion 11 comprises a diode-connected bipolar transistor 17 having both the base and collector electrodes coupled together for receiving a power supply voltage V_{DD}. Reference current portion 12 comprises a bipolar transistor 18 having the collector electrode thereof coupled to power supply voltage V_{DD}, a base electrode coupled to the base and collector electrodes of bipolar transistor 17 and an emitter electrode. The emitter electrode of transistor 18 is coupled to a first terminal of a resistor 19.

Unity gain amplifier portion 13 comprises P-channel transistors 21 and 22 and N-channel transistors 23 and 24. Buffer portion 15 comprises N-channel transistors 25 and 26. P-channel transistor 21 has a source electrode coupled to an emitter electrode of transistor 17 and a gate electrode coupled to its drain electrode, to a gate electrode of transistor 22 and to a drain electrode of transistor 25. P-channel transistor 22 has a source electrode coupled to a second terminal of resistor 19 and a drain electrode coupled to a gate electrode of transistors 25, to a gate electrode of transistor 26 and to a drain electrode of transistor 24. A source electrode of transistor 25 is coupled to both a drain electrode and a gate electrode of transistor 23 and to a gate electrode of transistor 24. Transistors 23 and 24 each have a source electrode coupled to a second supply voltage Vₛₛ which is more negative than supply voltage V_{DD}. Therefore, transistors 21 and 23 are effectively coupled as diodes.

Bias current portion 14 comprises a P-channel transistor 27 and an N-channel transistor 28. Transistor 27 has a source electrode coupled to supply voltage V_{DD} and both a gate electrode and a drain electrode coupled together to provide an output bias reference voltage. A drain electrode of transistor 26 of buffer portion 15 is coupled to the drain electrode of transistor 27 and a source electrode of transistor 26 is coupled to a drain electrode of transistor 28. Agate electrode of transistor 28 is coupled to the gate electrodes of transistors 23 and 24 and the drain electrode of transistor 23. A source electrode of transistor 28 is coupled to supply voltage Vₛₛ.

In a preferred form, each source electrode of N-channel transistors 23, 24, 25, 26 and 28 is coupled to the respective substrate thereof. Although the present invention may be practiced without connecting the source electrode and substrate of each of these transistors, the threshold voltage of each transistor connected in this manner is effectively lowered. Therefore, a lower voltage is required to make N-channel transistors 23, 24, 25, 26 and 28 conductive which allows for a greater voltage operation.

In operation, transistor 17 provides a fixed reference voltage which is equal to the V_{BE} of transistor 17. Transistor 18 also has a base-to-emitter voltage associated therewith. To utilize a delta V_{BE} current source, the current densities of transistors 17 and 18 must be different so that transistors 17 and 18 have a different V_{BE} voltage. Applying Kirchoffs voltage law to the loop formed by transistors 17, 18, 21 and 22 and resistor 19, if transistors 21 and 22 are matched devices having equal current densities, it can be readily shown that the voltage across resistor 19 is equal to the difference between the base-to-emitter voltages of transistors 17 and 18, delta V_{BE}. Resistor 19 therefore provides an accurate reference current through transistors 22 and 24. A proportional reference current is mirrored or reflected through series- connected transistors 21, 25 and 23.

Transistors 23, 24 and 25 function as a current source. Since transistors 17,21 and 23 are connected functionally as diodes, the majority of the voltage potential between V_{DD} and Vₛₛ is across the drain and source electrodes of transistor 25. Transistors 23 and 24 have a substantially constant voltage potential existing across the current electrodes thereof. The voltage potential across the drain and source electrodes of transistor 24 is the sum of the gate to source voltage of transistor 24 and the gate to source voltage of transistor 25. The voltage potential across the drain and source electrodes of transistor 23 is the gate to source voltage of transistor 23. Thus transistor 25 buffers transistor 23 from most of the voltage potential between V_{DD} and Vₛₛ by having most of the voltage potential across its drain and source electrodes.

To establish the output bias reference voltage at the gate electrode of transistor 27, transistor 28 is coupled to transistor 23 so that a bias current, I, flows through transistor 28. Bias current I is proportional to or is the same current which flows through transistor 23. Further, substantially the same voltage which appears across the gate and source electrodes of transistor 23 also appears across the gate and source electrodes of transistor 28. Transistor 26 is a cascode device and performs an analogous function to transistor 25 by having most of the voltage potential between V_{DD} and Vₛₛ across its drain and source electrodes instead of this voltage appearing across transistor 28. By applying Kirchoff's voltage law to the loop formed by transistors 23, 25, 26 and 28, it can be readily seen that the voltage which exists across the gate and source electrodes of transistors 25 and 26 are substantially equal in magnitude. Since the drain to source voltage of each of transistors 23, 24 and 28 is small in comparison with the voltage differential of V_{DD} and Vₛₛ, the natural impedance of each transistor is large and is therefore not decreased by impact ionization. Additionally, by having a small drain to source voltage across each of transistors 23, 24 and 28, the effect of matching errors associated with these transistors is minimized. Further, transistors 25 and 26 absorb any variation in the difference between V_{DD} and Vₛₛ without affecting the current through each transistor. Therefore, the effective impedance of current source 20 is greatly increased.

To fully appreciate the advantages of the higher effective impedance provided by buffer portion 15, consider the operation of current source 10 without transistors 25 and 26, without transistor 23 being diode-connected and with transistor 24 being diode-connected. In such a circuit configuration, the voltage across transistor 23 is typically much higher than the voltage across transistor 24 which is diode-connected. Due to the fact that transistors 23 and 24 have a finite output impedance caused by channel length modulation, the current mismatch between transistors 23 and 24 translates into an offset voltage across resistor 19 which provides an error in the output bias current. As the voltage across the drain electrode of transistor 23 increases, the amount of offset voltage across resistor 19 increases proportionately. The output bias voltage error becomes more pronounced at high voltage levels on N-channel transistors due to impact ionization. Impact ionization is a phenomenon in which charge carriers are lost to the substrate at increasingly higher drain to source voltage potentials thereby decreasing the impedance of the transistors. The effect of a reduced transistor impedance is an increase in the offset voltage across resistor 19 which thereby increases the output bias current, I.

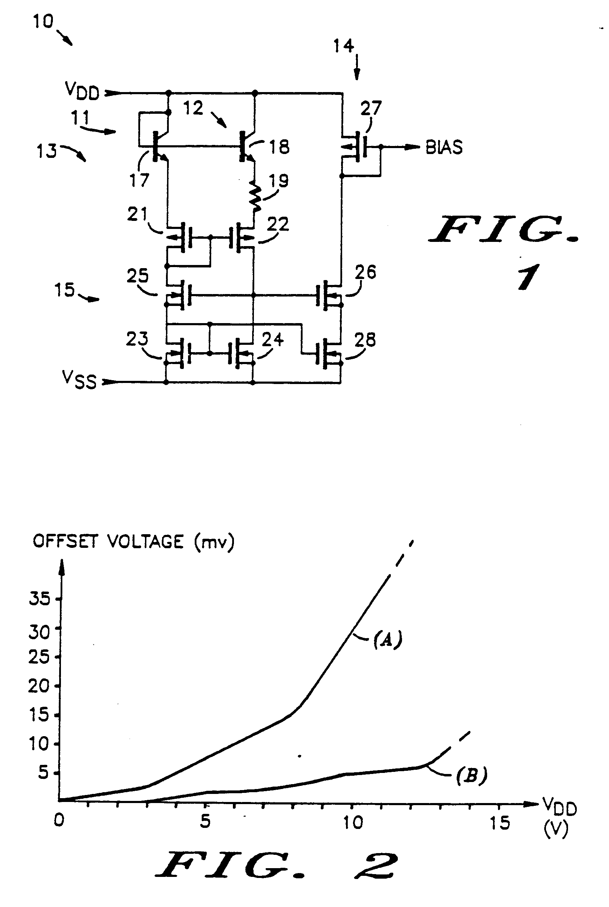

Shown in Fig. 2 is a graph which illustrates in curve (A) the offset voltage across resistor 19 for a range of V_{DD} supply voltages if transistors 25 and 26 are removed from current source 10 and if transistor 24 is diode-connected and transistor 23 is not diode-connected. Also shown in curve (B) of Fig. 2 is a graph illustrating the offset voltage across resistor 19 for the same range of Vpp supply voltages for the present invention illustrated in Fig. 1. As can be readily seen, a substantial reduction in offset voltage and therefore supply voltage dependency and output bias current error is achieved by the present invention.

It should be readily apparent that in order to prevent the possibility of an inactive state, a conventional start-up circuit (not shown) is required to allow start-up current to flow through reference voltage portion 11 when the output bias is below a predetermined threshold.

## Claims

1. A current source circuit having reduced error, comprising:
a reference voltage means (11) comprising a first bipolar transistor (17) having a first current electrode and a control electrode connected together and coupled to a first supply voltage (VDD) for receiving a first supply voltage and having a second current electrode, said reference voltage means (11) providing a reference voltage proportional to a bias current outputted by said current source circuit;
reference current means (12) comprising a second bipolar transistor (18) having a first current electrode coupled to the first supply voltage (VDD), a control electrode connected to the control electrode of the first bipolar transistor, and a second current electrode, and
a resistor (19) having a first terminal connected to the second current electrode of the second bipolar transistor (18) and a second terminal, said reference current means (12) providing a reference current proportional to the reference voltage;
unity gain amplifier means (13) having a predetermined ouput impedence, said amplifier means (13) comprising a third, MOS, transistor (21) of a first conductivity type having a first current electrode connected to the second current electrode of said first bipolar transistor (17), and a second current electrode and a control electrode which are connected together,
a fourth, MOS, transistor (22) of said first conductivity type having a first current electrode connected to the second terminal of the resistor (19), a control electrode connected to both the control electrode and second current electrode of the third transistor (21), and a second current electrode,
a fifth, MOS, transistor (24) of a second conductivity type having a first current electrode connected to the second current electrode of the fourth transistor (22), a second current electrode coupled to a second supply voltage terminal for receiving a second supply voltage (VSS), and a control electrode, and
a sixth, MOS, transistor (23) of the second conductivity type having a first current electrode connected to a control electrode thereof and to the control electrode of the fifth transistor (24), and having a second current electrode coupled to the second supply voltage terminal (VSS), said unity gain amplifier means (13) providing a bias voltage proportional to said reference current;
buffer means (15) comprising a seventh, MOS, transistor (25) of said second conductivity type having a first current electrode connected to the second current electrode of the third transistor (21), a second current electrode connected to the first current electrode of the sixth transistor (23), and a control electrode, and
an eighth, MOS, transistor (26) of the second conductivity type having first and second current electrodes, and a control electrode connected to the control electrode of the seventh transistor (25), to the second current electrode of said fourth transistor (22) and to the first current electrode of the fifth transistor (24), said buffer means (15) substantially increasing the output impedence of said unity gain amplifier, thereby decreasing power supply variation dependency; and
bias current means (14) comprising a ninth, MOS, transistor (27) of the first conductivity type having a first current electrode coupled to the first supply voltage terminal (VDD), and a control electrode connected to both a second current electrode thereof and the first current electrode of the eighth transistor (26), and
a tenth, MOS, transistor (28) of the second conductivity type having a first current electrode connected to the second current electrode of the eighth transistor (26), a control electrode connected to the control electrodes of the fifth (24) and sixth (23) transistors and to the first current electrode of the sixth transistor (23) and having a second current electrode coupled to the second power supply voltage (VSS), said bias current means (14) providing said output bias current, proportional to said bias voltage.

## Patentansprüche

1. Eine Stromquellenschaltung mit verminderter Abweichung, die umfaßt:
eine Bezugsspannungseinrichtung (11), die einen ersten bipolaren Transistor (17) mit einer ersten Stromelektrode und einer Steuerelektrode, die mit einander verbunden sind und an eine erste Speisespannung (VDD) zum Empfang einer ersten Speisespannung angeschlossen sind, sowie mit einer zweiten Stromelektrode umfaßt, wobei die Bezugsspannungseinrichtung (11) eine Bezugsspannung erzeugt, die einem Steuerstrom proportional ist, der von der Stromquellenschaltung ausgegeben wird;
Bezugsstromeinrichtung (12), die einen zweiten bipolaren Transistor (18) mit einer ersten Stromelektrode, die an die erste Speisespannung (VDD) angeschlossen ist, mit einer Steuerlektrode, die an die Steuerelektrode des ersten bipolaren Transistors angeschlossen ist, und mit einer zweiten Stromelektrode umfaßt, und
einen Widerstand (19) mit einem ersten Anschluß, der an die zweite Stromelektrode des zweiten bipolaren Transistors (18) angeschlossen ist, sowie mit einem zweiten Anschluß, wobei die Bezugsstromeinrichtung (12) einen Bezugsstrom erzeugt, der der Bezugsspannung proportional ist;
eine Verstärkungseinrichtung (13) mit dem Verstärkungsfaktor 1, die eine vorgegebene Ausgangsimpedanz hat, wobei die Verstärkungseinrichtung (13) einen dritten, einen MOS-Transistor (21) eines ersten Leitfähigkeitstyps mit einer ersten Stromelektrode umfaßt, die an die zweite Stromelektrode des ersten bipolaren Transistors (17) angeschlossen ist, sowie mit einer zweiten Stromelektrode und einer Steuerelektrode, die miteinander verbunden sind,
einen vierten, einen MOS-Transistor (22) des ersten Leitfähigkeitstyps mit einer ersten Stromelektrode, die an den zweiten Anschluß des Widerstandes (19) angeschlossen ist, mit einer Steuerelektrode, die sowohl an die Steuerelektrode als auch an die zweite Stromelektrode des drittten Transistors (21) angeschlossen ist, sowie mit einer zweiten Stromelektrode,
einen fünften, einen MOS-Transistor (24) eines zweiten Leitfähigkeitstyps mit einer ersten Stromelektrode, die an die zweite Stromelektrode des vierten Transistors (22) angeschlossen ist, mit einer zweiten Stromelektrode, die an einen zweiten Speisespanungsanschluß angeschlossen ist und eine zweite Speisespannung (VSS) empfängt, sowie mit einer Steuerelektrode, und einen sechsten, einen MOS-Transistor (23) des zweiten Leitfähigkeitstyps mit einer ersten Stromelektrode, die an eine Steuerelektrode desselben und an die Steuerelektrode des fünften Transistors (24) angeschlossen ist, und mit einer zweiten Stromelektrode, die an den zweiten Speisespannungsanschluß (VSS) angeschlossen ist, wobei die Verstärkungseinrichtung (13) mit dem Verstärkungsfaktor 1 eine Steuerspannung erzeugt, die dem Bezugsstrom proportional ist; eine Puffereinrichtung (15), die einen siebenten, einen MOS-Transistor (25) des zweiten Leitfähigkeitstyps mit einer ersten Stromelektrode umfaßt, die an die zweite Stromelektrode des dritten Transistors (21) angeschlossen ist, mit einer zweiten Stromelektrode, die an die erste Stromelektrode des sechsten Transistors (23) angeschlossen ist, sowie mit einer Steuerelektrode, und
einen achten, einen MOS-Transistor (26) des zweiten Leitfähigkeitstyps mit einer ersten und einer zweiten Stromelektrode sowie einer Steuerelektrode, die an die Steuerelektrode des siebenten Transistors (25), an die zweite Stromelektrode des vierten Transistors (22) und an die erste Stromelektrode des fünften Transistors (24) angeschlossen ist, wobei die Puffereinrichtung (15) die Ausgangsimpedanz des Verstärkers mit dem Verstärkungsfaktor 1 wesentlich erhöht und dadurch die Schwankung der Spannungszufuhr verringert; und
eine Steuerstromeinrichtung (14), die einen neunten, einen MOS-Transistor (27) des ersten Leitfähigkeitstyps mit einer ersten Stromelelektrode, die an den ersten Speisespannungsanschluß (VDD) angeschlossen ist, sowie mit einer Steuerelektrode umfaßt, die sowohl an die zweite Stromelektrode desselben als auch an die erste Stromelektrode des achten Transistors (26) angeschlossen ist, und
einen zehnten, einen MOS-Transistor (28) des zweiten Leitfähigkeitstyps mit einer ersten Stromelektrode, die an die zweite Stromelektrode des achten Transistors (26) angeschlossen ist, mit einer Steuerelektrode, die an die Steuerelektroden des fünften (24) und des sechsten (23) Transistors und an die erste Stromelektrode des sechsten Transistors (23) angeschlossen ist, sowie mit einer zweiten Stromelektrode, die an die zweite Spannungsversorgungsspannung (VSS) angeschlossen ist, wobei die Steuerstromeinrichtung (14) den Ausgangssteuerstrom erzeugt, der der Steuerspannung proportional ist.

## Revendications

1. Circuit source de courant à erreur réduite, comprenant:
un moyen de tension de référence (11) comprenant un premier transistor bipolaire (17) qui possède une première électrode de courant et une électrode de commande connectées ensemble et à une première borne de tension d'alimentation électrique (V_{DD}) délivrant une première tension d'alimentation, et qui possède une deuxième électrode de courant, ledit moyen de tension de référence (11) produisant une tension de référence qui est proportionnelle à un courant de polarisation délivré par ledit circuit source de courant;
un moyen de courant de référence (12) comprenant un deuxième transistor bipolaire (18) qui possède une première électrode de courant connectée à la première borne de tension d'alimentation électrique (V_{DD}), une électrode de commande connectée à l'électrode de commande du premier transistor bipolaire, et une deuxième électrode de courant, et
une résistance (19) qui possède une première borne connectée à la deuxième électrode de courant du deuxième transistor bipolaire (18) et une deuxième borne, ledit moyen de courant de référence (12) produisant un courant de référence qui est proportionnel à la tension de référence;
un moyen amplificateur à gain unité (13) qui possède une impédance de sortie prédéterminée, ledit moyen amplificateur (13) comprenant un troisième transistor, de type MOS, (21) d'un premier type de conductivité qui possède une première électrode de courant connectée à la deuxième électrode de courant dudit premier transistor bipolaire (17), ainsi qu'une deuxième électrode de courant et une électrode de commande qui sont connectées ensemble,
un quatrième transistor, de type MOS, (22) dudit premier type de conductivité qui possède une première électrode de courant connectée à la deuxième borne de résistance (19), une électrode de commande connectée à la fois à l'électrode de commande et à la deuxième électrode de courant dudit troisième transistor (21), et une deuxième électrode de courant,
un cinquième transistor, de type MOS, (24) d'un deuxième type de conductivité qui possède une première électrode de courant connectée à la deuxième électrode de courant du quatrième transistor (22), une deuxième électrode de courant connectée à une deuxième borne de tension d'alimentation électrique délivrant une deuxième tension d'alimentation électrique (Vₛₛ), et une électrode de commande, et
un sixième transistor, de type MOS, (23) du deuxième type de conductivité qui possède une première électrode de courant connectée à son électrode de commande et à l'électrode de commande du cinquième transistor (24), et qui possède une deuxième électrode de courant connectée à la deuxième borne de tension d'alimentation électrique (Vₛₛ), ledit moyen amplificateur à gain unité (13) produisant une tension de polarisation qui est proportionnelle audit courant de référence;
un moyen formant un tampon (15), comprenant un septième transistor, de type MOS, (25) dudit deuxième type de conductivité qui possède une première électrode de courant connectée à la deuxième électrode de courant du troisième transistor (21), une deuxième électrode de courant connectée à la première électrode de courant du sixième transistor (23), et une électrode de commande, et
un huitième transistor, de type MOS, (26) du deuxième type de conductivité qui possède des première et deuxième électrodes de courant, et une électrode de commande connectée à l'électrode de commande du septième transistor
(25), à la deuxième électrode de courant dudit quatrième transistor (22) et à la première électrode de courant du cinquième transistor (24), ledit moyen qui forme un tampon (15) augmentant sensiblement l'impédance de sortie dudit amplificateur à gain unité, ce qui a pour effet de diminuer la dépendance vis-à-vis des variations de l'alimentation électrique; et
un moyen de courant de polarisation (14) comprenant un neuvième transistor, de type MOS, (27) du premier type de conductivité qui possède une première électrode de courant connectée à la première borne de tension d'alimentation électrique (V_{DD}), et une électrode de commande connectée à la fois à sa deuxième électrode de courant et à la première électrode de courant du huitième transistor (26), et
un dixième transistor, de type MOS (28), du deuxième type de conductivité qui possède une première électrode de courant connectée à la deuxième électrode de courant du huitième transistor (26), une électrode de commande connectée aux électrodes de commande des cinquième et sixième transistors (24, 23) et à la première électrode de courant du sixième transistor (23), et qui possède une deuxième électrode de courant connectée à la deuxième borne de tension d'alimentation électrique (Vₛₛ), ledit moyen de courant de polarisation (14) produisant ledit courant de polarisation de sortie, qui est proportionnel à ladite tension de polarisation.
